# EUROPÄISCHE PATENTANMELDUNG

(11) **EP 3 447 507 A1**
(43) Veröffentlichungstag der Anmeldung: **27.02.2019**
(21) Anmeldenummer: 17187217.9
(22) Anmeldetag: 22.08.2017
(51) Int. Cl.: G01R 31/12, G01R 31/14

(54) **MOBILE TEILENTLADUNG-PRÜFEINRICHTUNG**

(71) Anmelder: Alpha Elektrotechnik AG, 2560 Nidau (CH)
(72) Erfinder: Bertschi, Beat, 5044 Schlossrued (CH)
(74) Vertreter: Schaad, Balass, Menzl & Partner AG

(57) **Zusammenfassung**

Prüfeinrichtung (4) zur Prüfung von elektrischen Hochspannungs- und Mittelspannungsanlagen sowie Komponenten davon, insbesondere elektrischen Kabeln vorzugsweise auf Zügen, auf Spannungsfestigkeit und Teilentladungen. Die Prüfeinrichtung (4) umfasst eine Spannungsquelle (6) zur Erzeugung einer einstellbaren Wechselspannung, einen Hochspannungstransformator (8) dessen Niederspannungswicklung (9) mit der Spannungsquelle (6) verbunden bzw. verbindbar ist und zu dessen Hochspannungswicklung (18) eine Serienschaltung eines Koppelkondensators (20) und eines Vierpols (22) parallel geschaltet ist. Die Hochspannungswicklung (18) ist hochspannungsseitig mit dem Koppelkondensator (20) und einem Anschluss (24) für einen Prüfling (16) und niederspannungsseitig mit einer mit einem Isoliergas gefüllten Metallkapselung (26) verbunden. Wenigstens der Hochspannungstransformator (8) und der Koppelkondensator (20) sind in der Metallkapselung (26) angeordnet und der Vierpol (22) ist mit einem Teilentladungsmessgerät (28) verbunden bzw. verbindbar.

## Beschreibung

Die Erfindung betrifft eine mobile Prüfeinrichtung zur Prüfung von elektrischen Hochspannungs- und Mittelspannungsanlagen sowie Komponenten davon, insbesondere elektrischen Kabeln, auf Spannungsfestigkeit und Teilentladungen gemäss Anspruch 1.

Die Prüfeinrichtung eignet sich insbesondere zur Vor-Ort-Prüfung von Kabeln auf Eisenbahnzügen.

Ein mobiles Teilentladungsdiagnosesystem wird zum Beispiel von der Firma Baur Gmbh unter dem Produktnamen PD-TaD 60 vermarktet und im Datenblatt 816-077-7 04.2016 offenbart. Das Testsystem umfasst eine Hochspannungsquelle mit einem Anschluss für einen Prüfling, eine Serienschaltung eines Koppelkondensators und einer Messimpedanz, welche an die Hochspannungsquelle angeschlossenen ist, ein Teilentladung-Messgerät zur Erfassung von durch Teilentladungen verursachten Signalen, und eine an die Hochspannungsquelle angeschlossene Spannungsquelle zur Erzeugung einer einstellbaren Wechselspannung. Das Diagnosesystem ist tragbar und für einen mobilen Einsatz im Feld geeignet.

Die Auskopplung der im Prüfling generierten Teilentladungen-Signale erfolgt dabei über die Messimpedanz, beispielsweise einen Vierpol. Durch den lokalen Isolationszusammenbruch, d. h. Teilentladung, im Prüfling wird ein impulsartiger Nachladestrom im parallel zum Prüfling angeschlossenen Koppelkondensator verursacht, welcher in ein ladungsäquivalentes Spannungssignal durch die Messimpedanz konvertiert wird. Dieses Spannungssignal wird vom Teilentladung-Messgerät erfasst und verarbeitet.

Dieses Teilentladungsdiagnosesystem ist jedoch nicht vollständig berührungssicher, weil unter Spannung stehende Elemente des Diagnosesystems im Freien liegen und von einer Bedienungsperson berührt werden können.

Obwohl dieses Teilentladungsdiagnosesystem Störunterdrückung aufweist, besteht die Gefahr, dass Hintergrundrauschen das Resultat der Teilentladungsmessungen beeinflusst.

Tragbare Detektoren zur Feststellung von Teilentladungen in unter Spannung stehenden Anlagen, wie Verteilkabeln und/oder Ausrüstungen, sind auch bekannt, zum Beispiel aus dem Dokument DE 690 14 950 T2. Diese Detektoren sind jedoch keine Testsysteme, weil sie keine Prüfspannung erzeugen und Teilentladungen können folglich nur während des Betriebs der Anlage und nur bei Betriebsspannung ermittelt werden.

Aufgabe der vorliegenden Erfindung ist es somit, eine mobile Prüfeinrichtung zur Vor-Ort-Prüfung von elektrischen Hochspannungs- und Mittelspannungsanlagen sowie Komponenten davon, insbesondere elektrischen Kabeln vorzugsweise auf Eisenbahnzügen, auf Spannungsfestigkeit und Teilentladungen zur Verfügung zu stellen, welche berührungssicher ist, sowie gegenüber Hintergrundrauschen unempfindlicherer ist.

Diese Aufgabe wird erfindungsgemäss durch eine Teilentladung- Prüfeinrichtung gemäss Anspruch 1 gelöst. Bevorzugte Ausführungsformen der Erfindung sind in den abhängigen Ansprüchen wiedergegeben.

Die Erfindung betrifft eine Prüfeinrichtung zur Prüfung von elektrischen Hochspannungs- und Mittelspannungsanlagen sowie Komponenten davon, insbesondere elektrischen Kabeln vorzugsweise auf Eisenbahnzügen, auf Spannungsfestigkeit und Teilentladungen.

Die Prüfeinrichtung umfasst eine Spannungsquelle zur Erzeugung einer einstellbaren Wechselspannung. Ferner umfasst die Prüfeinrichtung einen Hochspannungstransformator dessen Niederspannungswicklung mit der Spannungsquelle verbunden bzw. verbindbar und von dieser gespeist ist. Zur Hochspannungswicklung des Hochspannungstransformators ist eine Serienschaltung eines Koppelkondensators und eines Vierpols parallel geschaltet. Die Hochspannungswicklung ist hochspannungsseitig mit dem Koppelkondensator und einem Anschluss für einen Prüfling und niederspannungsseitig mit einer Metallkapselung verbunden.

Die Metallkapselung ist in bekannter Weise durch einen aus Metall gefertigten Behälter gebildet, welcher gegen die Umgebung verschlossen, luft- und gasdicht, druckfest und vorzugsweise geerdet ist. Die Metallkapselung umschliesst einen Innenraum, d.h. den vom Behälter umschlossenen Raum, welcher mit Isoliergas gefüllt ist. Daher bildet der Behälter eine Abschirmung für die im Innenraum angeordneten Komponenten der Prüfeinrichtung. Vorzugsweise ist der Behälter aus Aluminium gefertigt, um Wartung und Korrosion zu vermeiden.

In einer bevorzugten Ausführungsform umfasst der Behälter einen Grundkörper, welcher einen Boden und einen auf dem Boden angeordneten, hohlzylinderförmigen, vorzugsweise kreiszylindrischen, Behältermantel aufweist, und einen Deckel, welcher einen kegelstumpfförmigen Deckelmantel und eine auf eine obere Öffnung des Deckelmantels aufgesetzte Decke aufweist. Es ist möglich, den Deckelmantel mit der Decke zu verschweissen. Vorzugsweise ist jedoch der Deckelmantel mit der Decke über eine erste Flanschverbindung luft- und gasdicht, beispielsweise mittels eines Dichtungsrings, verbunden. Diese Anordnung ermöglicht einen einfachen Zugang zum Innenraum für die Wartung und die Revision. Vorzugsweise ist der Boden mit dem Behältermantel verschweisst. Vorzugsweise sind der Grundkörper und der Deckel über eine zweite Flanschverbindung luft- und gasdicht, beispielsweise mittels eines Dichtungsrings, verbunden.

Zur einfachen Bewegung der Prüfeinrichtung ist vorzugsweise der Boden des Grundkörpers mit Laufrollen versehen. Ebenfalls ist es möglich, den Behälter, vorzugsweise den Deckel, mit einem Griff zu versehen, um die Prüfeinrichtung mit einer Hubvorrichtung zu bewegen.

Isoliergase, wie zum Beispiel SF₆ (Schwefelhexafluorid), Novec™ 4710, Kohlendioxid, Stickstoff oder eine Mischung davon können verwendet werden. Gegebenenfalls kann auch trockene, staub- und fremdpartikelfreie Luft verwendet werden. Die Isoliergase stehen unter Druck im Betrieb der Prüfeinrichtung. Dank der Verwendung eines Isoliergases sind die erforderlichen Isolierstrecken zwischen den im Behälter angeordneten Komponenten und zwischen den Komponenten und dem Behälter kürzer.

Bevorzugt steht das Isoliergas SF₆ im Betrieb unter einem Druck zwischen 1.1 und 1.8 bar absolut, vorzugsweise zwischen 1.5 und 1.8 bar absolut.

Es besteht die Möglichkeit den Druck des Isoliergases im Behälter in Abhängigkeit von der Prüfspannung anzupassen. Beispielsweise kann ein Gasdruck von 1.5 bar absolut ausreichend bei der Verwendung von SF₆ für einen Spannungsbereich bis 75kV sein.

Vorzugsweise ist der Behälter mit einem Gasanschluss versehen, um den Innenraum zu evakuieren und anschliessend das Isoliergas einzufüllen. Durch den Gasanschluss besteht die Möglichkeit, falls dies erforderlich ist, für den Transport das Isoliergas abzupumpen. Möglich ist auch das Isoliergas ganz abzupumpen und beispielsweise durch Stickstoff zu ersetzen. Vorzugsweise ist der Behälter als zusätzliche Sicherheit mit einem Überdruckventil oder mit einer Berstplatte versehen, um ein Bersten des Behälters in Extremsituationen zu vermeiden.

Wenigstens der Hochspannungstransformator und der Koppelkondensator sind in der Metallkapselung, d.h. im Innenraum, angeordnet, um sie vor Störsignalen zu schützen und um eine Berührung von einer Bedienungsperson zu vermeiden.

Der Vierpol ist mit einem Teilentladungsmessgerät verbunden. Vorzugsweise ist der Vierpol ins Teilentladungsmessgerät eingebaut. Vorzugsweise weist das Teilentladungsmessgerät eine optische Verbindung zwischen dessen Messeinheit und dessen Steuereinheit zu deren galvanischen Trennung auf. Auf dieser Weise wird eine Masseschleife vermieden und werden Störspannungen reduziert, was zu einer Reduzierung des Hintergrundrauschens bei einer Prüfung auf Teilentladung beiträgt. Vorzugsweise ist das Teilentladungsmessgerät an einen Computer zu dessen Steuerung und zur Visualisierung der Prüfresultate angeschlossen.

Mit dem Begriff Hochspannung und mit dem Begriff Mittelspannung ist hier eine Spannung zwischen 60kV und 110kV bzw. 3kV und 60kV gemeint.

In Rahmen dieser Anmeldung sind Induktivitäten durch Spulen und Kapazitäten durch Kondensatoren oder Streukapazitäten zwischen Komponenten der Prüfeinrichtung gebildet.

In einer bevorzugten Ausführungsform ist eine Kompensationsinduktivität zur Niederspannungswicklung des Hochspannungstransformators parallel geschaltet und ist vorzugsweise mindestens eine weitere Kompensationsinduktivität in Parallelschaltung zur Niederspannungswicklung des Hochspannungstransformators zuschaltbar, damit der kapazitive Strom durch den Prüfling nicht von der Spannungsquelle aufgebracht werden muss. Die Kompensationsinduktivität deckt die stetig vorhandene kapazitive Last der Prüfeinrichtung ab. Die weiteren Kompensationsinduktivitäten sind je nach Kapazität des Prüflings zuschaltbar und werden zugeschaltet, bis der in die Niederspannungswicklung des Hochspannungstransformators eingespeiste Strom am kleinsten ist. Dies führt dazu, dass der Autotransformator während einer Prüfung sich weniger erhitzt. Ferner, je kleiner der eingespeiste Strom ist, desto tiefer kann die Prüfeinrichtung abgesichert, und damit die freigesetzte Energie im Durchschlagsfall begrenzt werden.

Vorzugsweise sind die Kompensationsinduktivität und gegebenenfalls die mindestens eine weitere Kompensationsinduktivität in der Metallkapselung angeordnet. Natürlich ist es ebenfalls möglich, die Kompensationsinduktivität und gegebenenfalls die mindestens eine weitere Kompensationsinduktivität ausserhalb der Metallkapselung, oder die Kompensationsinduktivität in der Metallkapselung und gegebenenfalls die mindestens eine weitere Kompensationsinduktivität ausserhalb der Metallkapselung oder umgekehrt anzuordnen.

In einer bevorzugten Ausführungsform ist eine einen Spannungsteiler bildende Serienschaltung eines Hochspannungskondensators und eines Messkondensators parallel zur Hochspannungswicklung des Hochspannungstransformators geschaltet. Der Hochspannungskondensator ist vorzugsweise in der Metallkapselung angeordnet, um ihn vor Störsignalen zu schützen und um eine Berührung von einer Bedienungsperson zu vermeiden.

Vorzugsweise wird zur Bildung des Hochspannungskondensators eine bereits vorhandene Streukapazität zwischen Komponenten innerhalb der Metallkapselung genutzt. Beispielsweise kann der Hochspannungskondensator durch die Streukapazität zwischen der Hochspannungswicklung des Hochspannungstransformators und einem in der Metallkapselung in einem Abstand zur Hochspannungswicklung des Hochspannungstransformators angeordneten, isoliert aufgehängten Abschirmblech gebildet sein, welches mit dem Messkondensator verbunden bzw. verbindbar ist. Vorzugsweise ist der Abstand minimalisiert, jedoch nur soweit, dass es keinen Überschlag zwischen der Hochspannungswicklung des Hochspannungstransformators und dem Abschirmblech gibt.

Vorzugsweise ist ein hochohmiges Voltmeter mit eigener Energieversorgung (z.B. Batterie) parallel zum Messkondensator geschaltet, um die am Prüfling anliegende Spannung unabhängig von jeder Prüftätigkeit anzuzeigen.

In einer bevorzugten Ausführungsform ist ein Erdungsschalter parallel zur Hochspannungswicklung des Hochspannungstransformators anschliessbar, und vorzugsweise in der Metallkapselung angeordnet, um ein auf Hochspannungspotential liegende Ende der Hochspannungswicklung des Hochspannungstransformators mit der Metallkapselung zu verbinden. Der Erdungsschalter dient dazu, die Hochspannungswicklung des Hochspannungstransformators bei Nichtbetrieb zu erden. Vorzugsweise wird der Erdungsschalter handbetätigt. Vorzugsweise ist der Erdungsschalter in Stellung "geerdet" abschliessbar.

In einer bevorzugten Ausführungsform weist die Spannungsquelle einen Trenntransformator zur galvanischen Trennung von einem Speisenetz auf. Vorzugsweise besitzt der Trenntransformator einen geerdeten Schirm zwischen seinen beiden Wicklungen. Somit ist der nachgeschaltete Hochspannungstransformator vor Störsignalen zusätzlich geschützt.

In einer bevorzugten Ausführungsform ist ein abschliessbarer Hauptschalter zwischen dem Speisenetz und dem Trenntransformator eingebaut.

In einer bevorzugten Ausführungsform ist ein Erdleiter des Speisenetzes über eine Schraubverbindung mit einem Erdpunkt der Metallkapselung lösbar verbunden und bildet eine Erdverbindung.

In einer bevorzugten Ausführungsform lässt sich diese Erdverbindung derart öffnen, dass eine Trennstelle von aussen sichtbar ist. Dies ist genau dann zulässig, wenn der Erdleiter des Speisenetzes mit hochfrequenten und damit störenden Spannungssignalen beaufschlagt ist, und der Erdpunkt der Metallkapselung niederimpedant und robust mit einem zuverlässigeren Erdpunkt verbunden worden ist.

In einer bevorzugten Ausführungsform weist die Spannungsquelle ein Netzfilter auf, vorzugsweise auf der Sekundärseite des Trenntransformators. Somit ist der nachgeschaltete Hochspannungstransformator ebenfalls vor Störsignalen zusätzlich geschützt.

In einer bevorzugten Ausführungsform ist der Anschluss zum Prüfling durch eine vorzugsweise koaxiale Steckerbuchse gebildet, die die Metallkapselung, vorzugsweise den Deckel, durchgreift und eine Durchführung bildet. Vorzugsweise wird die Steckerbuchse mit Hilfe eines an ihr vorgesehenen Montageflansches in luft- und gasdichter Weise befestigt.

In einer bevorzugten Ausführungsform ist ein in die Steckerbuchse eingesteckter Stecker direkt oder über ein Überbrückungskabel mit dem Prüfling verbunden bzw. verbindbar.

Nach der Montage des Steckers am Prüfling kann der Stecker einfach und sicher in die Steckerbuchse eingesteckt werden. Somit sind keine aufwendigen Vorbereitungsarbeiten am Prüfort nötig, bevor der Prüfling auf Spannungsfestigkeit und Teilentladungen geprüft werden kann.

In einer bevorzugten Anordnung wird der Prüfling mit dem Überbrückungskabel verbunden, beispielsweise über eine weitere Steckverbindung, und wird das mit dem Stecker versehene Überbrückungskabel an die Steckerbuchse angeschlossen. Die Verwendung des Überbrückungskabels ist vorteilhaft, beispielsweise falls die Prüfeinrichtung nicht nah genug zum Prüfling gebracht werden kann, oder die Stecksysteme der Prüfeinrichtung und des Prüflings nicht kompatibel sind.

Vorzugsweise weist das Überbrückungskabel einen Erdungsmantel und vorzugsweise einen radial ausserhalb des Erdungsmantels angeordneten Wellschlauch auf. Vorzugsweise ist der Erdungsmantel und gegebenenfalls der Wellschlauch über den Stecker und die Steckerbuchse mit der Metallkapselung verbunden. Der Wellschlauch dient dazu, das Überbrückungskabel zu schützen und seine Abschirmung zu erhöhen, um Störsignale zusätzlich zu reduzieren.

Vorzugsweise sind die Steckerbuchse und der Stecker, gegebenenfalls die weitere Steckverbindung, so ausgebildet, dass beim eingesteckten Stecker ein Erdungsmantel des Prüflings, und gegebenenfalls der Erdungsmantel des Überbrückungskabels, mit der Metallkapselung verbunden sind. Bei der Verwendung eines Überbrückungskabels ist die weitere Steckverbindung ebenfalls so ausgebildet, dass der Erdungsmantel des Prüflings mit dem Erdungsmantel des Überbrückungskabels verbunden ist. Auf dieser Weise sind die Prüfeinrichtung, der Prüfling, und gegebenenfalls das Überbrückungskabel, gemeinsam abgeschirmt.

Andere Anschlüsse sind ebenfalls möglich, wie beispielsweise eine Verbindung der Metallkapselung mit einem Rohr eines ebenfalls luft- und gasisolierten, gekapselten Prüflings. Es ist auch möglich, einen Anschluss in der Form einer Freiluft-Durchführung zu gestalten, welche mit dem Prüfling verbunden wird.

Die Prüfeinrichtung wird bevorzugt bei der Prüfung auf Spannungsfestigkeit und Teilentladungen von auf Eisenbahnzügen montierten Mittelspannungskabeln eingesetzt, insbesondere vor Ort. Allerdings können geschirmte und nichtgeschirmte Hochspannungs- und Mittelspannungsanlagen sowie Komponenten davon geprüft werden, z.B. geschirmte Mittelspannungswandler. Mit dieser mobilen Prüfeinrichtung ist kein speziell ausgestattetes Prüflabor am Montageort nötig und Mittelspannungskabel können nach dem Zusammenbau in ihrem montierten Zustand geprüft werden.

Diese Prüfeinrichtung ermöglicht Teilentladungensmessungen mit einem Hintergrundrauschen kleiner als 2pC.

In bekannter Weise kann beispielsweise die Prüfung so durchgeführt werden, dass die angelegte Prüfspannung allmählich bis zu einem vorbestimmten Prüfwert erhöht wird, und gleichzeitig festgestellt wird, ob Teilentladungen stattfinden. Daraus können Schlussfolgerungen zum Zustand der Prüflingsisolierung gezogen werden. Es ist auch möglich, die angelegte Prüfspannung allmählich zu erhöhen, bis Teilentladungen festgestellt werden und daraus Schlussfolgerungen zum Zustand der Prüflingsisolierung zu ziehen. Üblicherweise wird die angelegte Prüfspannung gefahren, und anschliessend beim Herunterregeln der angelegten Prüfspannung die Teilentladungen gemessen, wobei gewisse Kriterien an Teilentladungs-Niveau und Teilentladungs-Aussetzspannung eingehalten werden müssen. Diese Beispiele schliessen andere Prüfprotokolle nicht aus.

Die Prüfspannung kann dieselbe Frequenz wie das Speisenetz aufweisen, wenn die Prüfeinrichtung direkt an das Speisenetz angeschlossen ist, oder eine einstellbare Frequenz aufweisen, wenn ein Frequenzgenerator zwischen dem Speisenetz und der Prüfeinrichtung verwendet wird.

Weitere Vorteile und Eigenschaften der Erfindung gehen aus der nachstehenden Beschreibung eines Ausführungsbeispiels hervor, welches anhand der beiliegenden Figuren erläutert wird.

Diese zeigen rein schematisch:
- Fig. 1: ein Ersatzschaltbild einer erfindungsgemässen Prüfeinrichtung; und
- Fig. 2: einen vertikalen Schnitt durch die erfindungsgemässe Prüfeinrichtung.

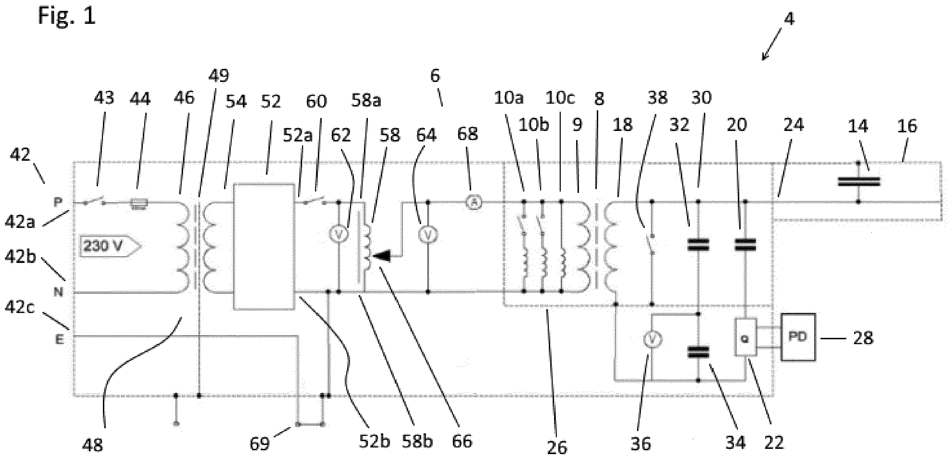

Ein Ersatzschaltbild einer Prüfeinrichtung zur Prüfung von elektrischen Hochspannungs- und Mittelspannungsanlagen sowie Komponenten davon, insbesondere elektrischen Kabeln vorzugsweise auf Eisenbahnzügen, auf Spannungsfestigkeit und Teilentladungen geht aus Fig. 1 hervor.

Im gezeigten Ausführungsbeispiel umfasst die Prüfeinrichtung 4 eine Spannungsquelle 6 zur Erzeugung einer einstellbaren Wechselspannung, und einen Hochspannungstransformator 8.

Weiter ist eine Kompensationsinduktivität 10c an die Niederspannungswicklung 9 des Hochspannungstransformators 8 parallel angeschlossen. Ebenfalls sind zwei Kompensationsinduktivitäten 10a und 10b an die Niederspannungswicklung 9 des Hochspannungstransformators 8 parallel anschliessbar. Die Kompensationsinduktivitäten 10a, 10b und 10c dienen dazu, die Prüfeinrichtung 4 an die Prüflingskapazität 14 eines zu prüfenden Prüflings 16 anzupassen. Somit kann der in die Niederspannungswicklung 9 des Hochspannungstransformators 8 eingespeiste Strom auf ca. 20 A beschränkt werden.

Die Niederspannungswicklung 9 des Hochspannungstransformators 8 ist mit der Spannungsquelle 6 verbunden, welche nachstehend in Details beschrieben wird.

Zur Hochspannungswicklung 18 des Hochspannungstransformators 8 ist ferner eine Serienschaltung eines Koppelkondensators 20 und eines Vierpols 22 parallel geschaltet, wobei die Hochspannungswicklung 18 hochspannungsseitig mit dem Koppelkondensator 20 und einem Anschluss 24 für den Prüfling 16 und niederspannungsseitig mit einer Metallkapselung 26 verbunden ist.

Der Vierpol 22 ist mit einem Teilentladungsmessgerät 28 verbunden. Vorzugsweise ist der Vierpol 22 ins Teilentladungsmessgerät eingebaut. Beispielsweise kann ein Teilentladungsmessgerät des Typs Omicron MPD 500 der Firma Omicron verwendet werden.

Weiter ist eine einen Spannungsteiler 30 bildende Serienschaltung eines Hochspannungskondensators 32 und eines Messkondensators 34 parallel zur Hochspannungswicklung 18 des Hochspannungstransformators 8 geschaltet. Ein hochohmiges Voltmeter 36 ist parallel zum Messkondensator 34 zur Anzeige der am Prüfling 16 angelegten Spannung geschaltet.

Ferner ist ein Erdungsschalter 38 parallel zur Hochspannungswicklung 18 des Hochspannungstransformators 8 anschliessbar. Der Erdungsschalter 38 ist in der Metallkapselung 26 angeordnet, um das nicht fest geerdete Ende der Hochspannungswicklung 18 mit der Metallkapselung 26 bei Bedarf zu verbinden.

In dieser Ausführungsform sind der Hochspannungskondensator 32, der Hochspannungstransformator 8, der Koppelkondensator 20 und der Erdungsschalter 38, sowie die Kompensationsinduktivitäten 10a, 10b und 10c in der Metallkapselung 26 angeordnet.

Der Prüfling 16 ist mit seiner Prüflingskapazität 14 dargestellt und mit der Hochspannungswicklung 18 des Hochspannungstransformators 8 in Parallelschaltung verbunden.

Die Spannungsquelle 6 umfasst einen Netzanschluss 42 mit einem Phasenleiter 42a, einem Neutralleiter 42b und einem Erdleiter 42c. Der Netzanschluss 42 ist an ein eine Spannung von 230V und eine Netzfrequenz von 50Hz aufweisendes Speisenetz verbindbar.

Der Phasenleiter 42a ist über eine Serienschaltung eines Hauptschalters 43 und einer Sicherung 44 mit einem ersten Ende der Primärwicklung 46 eines Trenntransformators 48 verbunden, und das zweite Ende der Primärwicklung 46 ist an den Neutralleiter 42b angeschlossen. Der Trenntransformator 48 dient zur galvanischen Trennung vom Speisenetz sowie zur Unterdrückung von hochfrequenten Störsignalen.

Ferner umfasst die Spannungsquelle 6 einen Netzfilter 52, dessen Eingangsseite parallel zur Sekundärwicklung 54 des Trenntransformators 48 geschaltet ist, und einen Autotransformator 58.

Der Trenntransformator 48 besitzt einen geerdeten Schirm 49 zwischen der Primärwicklung 46 und der Sekundärwicklung 54. Somit ist der nachgeschaltete Hochspannungstransformator vor Störsignalen zusätzlich geschützt.

Ein Netzfiltersausgang 52a des Netzfilters 52 ist über einen Hochspannungsschalter 60 mit einem Wicklungseingang 58a des Autotransformators 58 verbindbar. Ein Wicklungsausgang 58b des Autotransformators 58 ist mit einem Erdpunkt der Metallkapselung und einem Erdungsausgang 52b des Netzfilters 52 verbunden.

Ein Eingangsvoltmeter 62 und ein Ausgangsvoltmeter 64 sind zum Autotransformator 58 eingangsseitig bzw. ausgangsseitig parallel geschaltet.

Der Autotransformator 58 weist ausgangsseitig einen variablen Abgriff 66 zur variablen Spannungsspeisung des Hochspannungstransformators 8 auf.

Ferner umfasst die Spannungsquelle 6 ein Amperemeter 68, welches zwischen den Abgriff 66 und die Niederspannungswicklung 9 hochspannungsseitig geschaltet ist.

Die Spannungsquelle 6 liefert typischerweise eine Spannung zwischen 0 und 230V bei einem maximalen Strom von 20A je nach Grösse der angeschlossenen Kompensationsinduktivitäten.

Der Erdleiter 42c ist über eine Schraubverbindung 69 mit dem Erdpunkt der Metallkapselung 26 lösbar verbunden und bildet eine Erdverbindung.

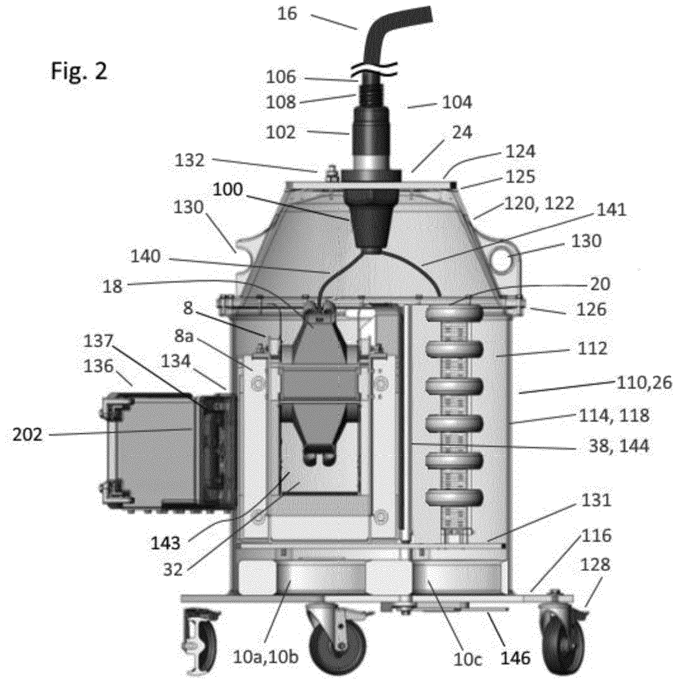

Die in Fig. 2 gezeigte Ausführungsform der Prüfeinrichtung mit der Metallkapselung 26 und mit dem Prüfling 16 ist entsprechend dem Ersatzschaltbild gemäss Fig. 1 aufgebaut, jedoch ohne detaillierte Darstellung der elektrischen Verbindungen.

Die Metallkapselung 26 ist durch einen aus Metall gefertigten Behälter 110 gebildet. Der Behälter 110 ist gegen die Umgebung verschlossen, luft- und gasdicht, druckfest und geerdet. Die Metallkapselung 26 umschliesst einen Innenraum 112, d.h. den vom Behälter 110 umschlossenen Raum, welcher mit Isoliergas gefüllt ist. Daher bildet der Behälter 110 eine Abschirmung für die im Innenraum 112 angeordneten Komponenten der Prüfeinrichtung 4. Vorzugsweise ist der Behälter 110 aus Aluminium gefertigt, um Wartung und Korrosion zu vermeiden.

Der Behälter 110 umfasst einen Grundkörper 114, welcher einen Boden 116 und einen auf dem Boden 116 angeordneten, kreiszylindrischen Behältermantel 118 aufweist, und einen Deckel 120, welcher einen kegelstumpfförmigen Deckelmantel 122 und eine Decke 124 aufweist. Der Deckelmantel 122 und die Decke 124 sind über eine erste Flanschverbindung 125 luft- und gasdicht, beispielsweise mittels eines Dichtungsrings, miteinander verbunden. Der Boden 116 ist eben und mit dem Behältermantel 118 verschweisst. Der Grundkörper 114 und der Deckel 120 sind über eine zweite Flanschverbindung 126 luft- und gasdicht, beispielsweise mittels eines Dichtungsrings, miteinander verbunden. Zur einfachen Bewegung der Prüfeinrichtung 4 ist der Boden 116 mit Laufrollen 128 versehen. Der Behälter 110 ist mit ringförmigen Griffen 130 versehen, um die Prüfeinrichtung 4 mit einer Hubvorrichtung zu bewegen.

Ferner weist der Behältermantel 118 eine seitliche Öffnung 134 auf, in welche ein luft- und gasdichter Durchführungsklemmenblock 137 eingelassen ist. Der Durchführungsklemmenblock 137 führt luft- und gasdicht vorzugsweise alle elektrischen Verbindungen von den in der Metallkapselung 26 angeordneten Komponenten in ein quaderförmiges Gehäuse 136 zur Verbindung über Anschlüsse mit den ausserhalb der Metallkapselung 26 angeordneten Komponenten.

Das Gehäuse 136 ist über eine dritte Flanschverbindung 202 mit dem Behälter 110 verbunden und so ausgebildet, dass es in die Schirmung der Metallkapselung 26 integriert ist.

Der Behälter 110 ist mit einem Gasanschluss 132 versehen, um den Innenraum 112 zu evakuieren und anschliessend mit Isoliergas zu füllen.

Vorzugsweise weist das Isoliergas SF₆ (Schwefelhexafluorid) auf bzw. ist durch dieses gebildet. Bevorzugt steht das Isoliergas im Betrieb unter einem Druck zwischen 1.1 und 1.8 bar absolut, vorzugsweise zwischen 1.5 und 1.8 bar absolut.

In dieser Ausführungsform umfasst der Behälter 110 weiter eine mit der Metallkapselung 26 verbundene Metallplatte 131, welche parallel zum Boden 116 im unteren, inneren Bereich des Grundkörpers 114 angeordnet ist.

Der Hochspannungstransformator 8 ist in der Metallkapselung 26 angeordnet und an der Metallplatte 131 befestigt. Seine Niederspannungswicklung 9 ist über einen Anschluss mit der Spannungsquelle 6 verbindbar. Im Betrieb wird der Hochspannungstransformator 8 von dieser Spannungsquelle 6 gespeist. Der Hochspannungstransformator 8 weist eine Kunststoff-Folie und SF6 enthaltende Lagenisolation auf. Typischerweise wird eine Prüfspannung bis zu 75kV an der Hochspannungswicklung 18 erreicht.

Eine Serienschaltung eines in der Metallkapselung angeordneten, an der Metallplatte 131 aufrecht stehend befestigten Koppelkondensators 20 und eines Anschlusses für einen ausserhalb der Metallkapselung 26 angeordneten Vierpol 22 ist parallel zur Hochspannungswicklung 18 des Hochspannungstransformators 8 geschaltet. Der Koppelkondensator 20 weist eine Kapazität zwischen 1 nF und 5 nF, vorzugsweise 3 nF auf.

Die Hochspannungswicklung 18 ist hochspannungsseitig über Anschlusskabel 140 und 141 mit dem Koppelkondensator 20 und mit einem Anschluss 24 für einen Prüfling 16 verbunden. Niederspannungsseitig ist die Hochspannungswicklung 18 mit der Metallkapselung 26 verbunden.

In der Metallkapselung 26 ist ebenfalls die Serienschaltung des Hochspannungskondensators 32 und eines Anschlusses für einen ausserhalb der Metallkapselung 26 angeordneten Messkondensator 34 angeordnet. Der Hochspannungskondensators 32 weist beispielsweise eine Kapazität zwischen 5 pF und 50 pF. Die Serienschaltung ist parallel zur Hochspannungswicklung 18 des Hochspannungstransformators 8 geschaltet. Der Hochspannungskondensator 32 ist durch die Streukapazität zwischen der Hochspannungswicklung 18 des Hochspannungstransformators 8 und einem isoliert aufgehängten Abschirmblech 143 gebildet, welches mit dem Messkondensator 34 verbunden bzw. verbindbar ist.

Die Niederspannungswicklung 9 ist um den Kern 8a gewickelt und die Hochspannungswicklung 18 ist koaxial aussenliegend bezüglich der Niederspannungswicklung 9 gewickelt.

Ferner ist der parallel zur Hochspannungswicklung 18 des Hochspannungstransformators 8 anschliessbare Erdungsschalter 38 in der Metallkapselung angeordnet. Der Erdungsschalter 38 weist einen senkrecht zum Boden 116 verlaufenden Metallschaft 144 auf, dessen erstes Ende durch einen luft- und gasdichten, im Boden 116 angeordneten Durchgang aus der Metallkapselung 26 herausragt und dessen anderes Ende bis zu einem oberen Bereich des Hochspannungstransformators 8 reicht. Das erste Ende ist mit einem Hebel 146 zur Drehung des Metallschafts 144 um seine Längsachse zwischen einer Offenstellung und einer Schliessstellung des Erdungskreises des Hochspannungstransformators 8 verbunden. Vorzugsweise wird der Hebel handbetätigt. Der Erdungsschalter dient dazu, die Hochspannungswicklung 18 des Hochspannungstransformators 8 in bei Bedarf zu erden.

Ebenfalls sind die Kompensationsinduktivität 10c und in der gezeigten Ausführungsform zwei weitere Kompensationsinduktivitäten 10a, 10b in der Metallkapselung 26 zwischen dem Boden 116 und der Metallplatte 131 angeordnet, um die Induktivität der Prüfeinrichtung 4 an die Prüflingskapazität 14 des Prüflings 16 anzupassen. Typischerweise können Prüflinge mit einer Prüflingskapazität 14 bis 8 nF geprüft werden.

Der Anschluss 24 ist durch eine Steckerbuchse 100 gebildet, die die Metallkapselung 26, in der gezeigten Ausführungsform die Decke 124, durchgreift und eine Durchführung bildet. Der Erdungsmantel der Steckerbuchse 100 ist mit der Metallkapselung 26 verbunden.

Nach der Montage eines an die Steckerbuchse 100 passenden Steckers 102 am Prüfling 16, kann der Stecker 102 in die Steckerbuchse 100 eingesteckt werden. Vorzugsweise werden Connex®-Stecker und Steckerbuchsen verwendet, die üblicherweise in Eisenbahnzügen für Mittelspannungsverbindungen eingesetzt werden.

In der gezeigten Ausführungsform ist ein Überbrückungskabel 104 zur Verbindung des Prüflings 16 mit der Steckerbuchse 100 abgebildet. Das Überbrückungskabel 104 weist einen Erdungsmantel 106 und einen radial ausserhalb des Erdungsmantels 106 angeordneten Wellschlauch 108 auf, um die Abschirmung des Überbrückungskabels 104 zu erhöhen und Störsignale zusätzlich zu reduzieren.

**Legende zu den Bezugszeichen**

| | |
|---|---|
| Prüfeinrichtung | 4 |
| Spannungsquelle | 6 |
| Hochspannungstransformator | 8 |
| Niederspannungswicklung | 9 |
| Induktivitäten | 10a, 10b, 10c |
| Prüflingskapazität | 14 |
| Prüfling | 16 |
| Hochspannungswicklung | 18 |
| Koppelkondensator | 20 |
| Vierpol | 22 |
| Anschluss zum Prüfling | 24 |
| Metallkapselung | 26 |
| Teilentladungsmessgerät | 28 |
| Spannungsteiler | 30 |
| Hochspannungskondensator | 32 |
| Messkondensator | 34 |
| Voltmeter | 36 |
| Erdungsschalter | 38 |
| Netzanschluss | 42 |
| Phasenleiter 42a, Neutralleiter 42b, Erdleiter 42c | |
| Hauptschalter | 43 |
| Sicherung | 44 |
| Primärwicklung | 46 |
| Trenntransformator | 48 |
| Schirm | 49 |
| Netzfilter | 52 |
| Netzfiltersausgang52a, Erdungsausgang 52b | |
| Sekundärwicklung | 54 |
| Autotransformator | 58 |
| Wicklungseingang 58a, Wicklungsausgang 58b | |
| Hochspannungsschalter | 60 |
| Eingangsvoltmeter | 62 |
| Ausgangsvoltmeter | 64 |
| Abgriff | 66 |
| Amperemeter | 68 |
| Schraubverbindung | 69 |
| Steckerbuchse | 100 |
| Stecker | 102 |
| Überbrückungskabel | 104 |
| Erdungsmantel | 106 |
| Wellschlauch | 108 |
| Behälter | 110 |
| Innenraum | 112 |
| Grundkörper | 114 |
| Boden | 116 |
| Behältermantel | 118 |
| Deckel | 120 |
| Deckelmantel | 122 |
| Decke | 124 |
| Erste Flanschverbindung | 125 |
| Zweite Flanschverbindung | 126 |
| Laufrollen | 128 |
| Griff | 130 |
| Metallplatte | 131 |
| Gasanschluss | 132 |
| seitliche Öffnung | 134 |
| Gehäuse | 136 |
| Durchführungsklemmenblock | 137 |
| Anschlusskabel | 140, 141 |
| Abschirmblech | 143 |
| Metallschaft | 144 |
| Hebel | 146 |
| dritte Flanschverbindung | 202 |

## Patentansprüche

1. Prüfeinrichtung (4) zur Prüfung von elektrischen Hochspannungs- und Mittelspannungsanlagen sowie Komponenten davon, insbesondere elektrischen Kabeln, auf Spannungsfestigkeit und Teilentladungen mit einer Spannungsquelle (6) zur Erzeugung einer einstellbaren Wechselspannung, einem Hochspannungstransformator (8) dessen Niederspannungswicklung (9) mit der Spannungsquelle (6) verbunden bzw. verbindbar ist und zu dessen Hochspannungswicklung (18) eine Serienschaltung eines Koppelkondensators (20) und eines Vierpols (22) parallel geschaltet ist, wobei die Hochspannungswicklung (18) hochspannungsseitig mit dem Koppelkondensator (20) und einem Anschluss (24) für einen Prüfling (16) und niederspannungsseitig mit einer mit einem Isoliergas gefüllten Metallkapselung (26) verbunden ist, wenigstens der Hochspannungstransformator (8) und der Koppelkondensator (20) in der Metallkapselung (26) angeordnet sind und der Vierpol (22) mit einem Teilentladungsmessgerät (28) verbunden bzw. verbindbar ist.

2. Prüfeinrichtung nach Anspruch 1, **dadurch gekennzeichnet, dass** eine Kompensationsinduktivität (10c) zur Niederspannungswicklung (9) des Hochspannungstransformators (8) parallel geschaltet ist und vorzugsweise mindestens eine weitere Kompensationsinduktivität (10a, 10b) in Parallelschaltung zur Niederspannungswicklung (9) des Hochspannungstransformators (8) zuschaltbar ist, um die Induktivität der Prüfeinrichtung (4) an die Kapazität des Prüflings (16) anzupassen.

3. Prüfeinrichtung (4) nach Anspruch 2, **dadurch gekennzeichnet, dass** die Kompensationsinduktivität (10c) und gegebenenfalls die mindestens eine weitere Kompensationsinduktivität (10a, 10b) in der Metallkapselung (26) angeordnet sind.

4. Prüfeinrichtung (4) nach einem der Ansprüche 1 bis 3, **dadurch gekennzeichnet, dass** eine einen Spannungsteiler (30) bildende Serienschaltung eines Hochspannungskondensators (32) und eines Messkondensators (34) parallel zur Hochspannungswicklung (18) des Hochspannungstransformators (8) geschaltet ist, wobei der Hochspannungskondensator (32) vorzugsweise in der Metallkapselung (26) angeordnet und vorzugsweise ein Voltmeter (36) parallel zum Messkondensator (34) geschaltet ist.

5. Prüfeinrichtung (4) nach einem der Ansprüche 1 bis 4, **dadurch gekennzeichnet, dass** der Hochspannungskondensator (32) durch eine Streukapazität zwischen der Hochspannungswicklung (18) des Hochspannungstransformators (8) und einem in der Metallkapselung (26) angeordneten, isoliert aufgehängten Abschirmblech (143) gebildet ist.

6. Prüfeinrichtung (4) nach einem der Ansprüche 1 bis 5, **gekennzeichnet durch** einen parallel zur Hochspannungswicklung (18) des Hochspannungstransformators (8) anschliessbaren, vorzugsweise in der Metallkapselung (26) angeordneten Erdungsschalter (38), um die Hochspannungswicklung (18) hochspannungsseitig mit der Metallkapselung (26) zu verbinden.

7. Prüfeinrichtung (4) nach einem der Ansprüche 1 bis 6, **dadurch gekennzeichnet, dass** die Spannungsquelle (6) einen Trenntransformator (48) zur galvanischen Trennung von einem Speisenetz aufweist.

8. Prüfeinrichtung (4) nach einem der Ansprüche 1 bis 7, **dadurch gekennzeichnet, dass** die Spannungsquelle (6) einen Netzfilter (52) aufweist, vorzugsweise an einer Sekundärseite des Trenntransformators (48).

9. Prüfeinrichtung (4) nach einem der Ansprüche 1 bis 8, **dadurch gekennzeichnet, dass** der Anschluss (24) durch eine Steckerbuchse (100) gebildet ist, die die Metallkapselung (26) durchgreift.

10. Prüfeinrichtung (4) nach Anspruch 9, **gekennzeichnet durch** einen in die Steckerbuchse (100) eingesteckten Stecker (102), welcher direkt oder über ein Überbrückungskabel (104) mit dem Prüfling (16) verbunden ist.

11. Prüfeinrichtung (4) nach einem der Ansprüche 1 bis 10, **dadurch gekennzeichnet, dass** das Überbrückungskabel (104) einen Erdungsmantel (106) und vorzugsweise einen radial ausserhalb des Erdungsmantels (106) angeordneten Wellschlauch (108) aufweist.
